(19) Europäisches Patentamt / European Patent Office / Office européen des brevets

(11) **EP 1 826 831 A1**

(12) **EUROPEAN PATENT APPLICATION**
published in accordance with Art. 158(3) EPC

(43) Date of publication:
**29.08.2007 Bulletin 2007/35**

(51) Int Cl.:
**H01L 33/00** *(2006.01)*    **H01S 5/028** *(2006.01)*

(21) Application number: **05809768.4**

(22) Date of filing: **25.11.2005**

(86) International application number:
**PCT/JP2005/021725**

(87) International publication number:
**WO 2006/057357 (01.06.2006 Gazette 2006/22)**

(84) Designated Contracting States:
**DE**

(30) Priority: **25.11.2004 JP 2004340645**
**25.11.2004 JP 2004340647**

(71) Applicant: **Mitsubishi Chemical Corporation**
**Minato-ku**
**Tokyo 108-0014 (JP)**

(72) Inventors:
• **OHNO, Akira**
**Mitsubishi Chemical Group Science**
**Yokohama-shi,**
**Kanagawa 2278502 (JP)**

• **MURASE, Tomohide**
**Mitsubishi Chemical Group Science**
**Yokohama-shi,**
**Kanagawa 2278502 (JP)**

(74) Representative: **HOFFMANN EITLE**
**Patent- und Rechtsanwälte**
**Arabellastraße 4**
**D-81925 München (DE)**

(54) **LIGHT-EMITTING DEVICE**

(57)    To improve either stability of emission characteristics with respect to time or with respect to inter-device fluctuation. On this purpose, in a light emitting device comprising the first luminescent material, and the second luminescent material absorbing light from said first luminescent material and emitting light, the phosphor included in said second luminescent material is used, the absorption spectrum of which satisfies the formula (1) below.

$$1 \geq P(\lambda)_{min} / P(\lambda)_{max} \geq 0.3 \qquad (\mathrm{I})$$

(In the formula (I) above, $P(\lambda)$ indicates the intensity of the absorption spectrum at the wavelength $\lambda$, $P(\lambda)_{max}$ indicates the maximum value of $P(\lambda)$ in the range of 400 nm $\leq \lambda \leq$ 450 nm, and $P(\lambda)_{min}$ indicates the minimum value of $P(\lambda)$ in the range of 400 nm $\leq \lambda \leq$ 450 nm.)

FIG. 3

**Description**

Technical Field

This invention relates to a light emitting device.

Background Art

1 ' As light emitting device used for such purposes as high emission-efficiency lighting system or display, a device is known which uses a solid light-emitting element such as light emitting diode (LED) or laser diode (LD) as the first luminescent material, and phosphor as constituent of the second luminescent material. Various devices based on this principle have been proposed.

In a light emitting device comprising the first light source and a phosphor which absorbs light from the first light source and emits the second light, it is known to use as phosphor microcrystals of III-V group semiconductor the volume of which is smaller than certain values. The use of such light emitting devices is said to be accompanied by high luminance and low power consumption, and result in long life span and low environmental burden (See Patent Document 1).
In the above Patent Document, it is stated that it is possible to obtain white fluorescence by using phosphors consisting of nanocrystals of III-V group semiconductors and by layering them in the order of red phosphor, green phosphor and blue phosphor. The combined use of light emitted from a GaN series light emitting element as exciting light makes possible a lighting system generating white light.

However, in a light emitting device used conventionally, emission characteristics (wavelength, brightness) of the first luminescent material fluctuate with time or fluctuate among individual luminescent materials, and this caused time-dependent or inter-device fluctuation of emission characteristics such as brightness or chromaticity. In order to control this time-dependent or inter-device fluctuation, the following measures have been taken:

(1) after a luminescent portion is constructed, a process is included in which a predetermined electric current, higher than that used at the time of ordinary use, is passed through the luminescent portion for a predetermined period, thereby stabilizing emission characteristics of the first luminescent material with respect to time (for example, Patent Document 2), (2) relation between chromaticity coordinates of LED and the phosphor is properly set (for example, Patent Document 3).

[Patent Document 1] Japanese Patent Laid-Open Publication (Kokai) No. 2004-83653
[Patent Document 2] Japanese Patent Laid-Open Publication (Kokai) No. 2003-318446
[Patent Document 3] US Patent No. 6538371B1

Disclosure of the Invention

Problem to Be Solved by the Invention

However, in the technology hitherto employed, fluctuation of emission characteristics with time or fluctuation of emission characteristics among individual devices can not be adequately controlled and further improvement has been desired. Also, in a light emitting device based on the second luminescent material using semiconductors of the III-V group of the long periodic table, color rendering was not satisfactory when an object was irradiated with light emitted from that device. In Patent Document 1 described above, it is stated that white light could be obtained by using LED as the first light source, and InN nanocrystals of specific volume as phosphor of the second light source. The degree of whiteness, however, is not clear and the details of production method of the phosphor are not clear, either. Therefore, adequate color rendering does not seem to have been attained.

Means for Solving the Problem

After an intensive investigation, the present inventors found that the above problem can be solved by minimizing the fluctuation in intensity of a specific wavelength of the absorption spectrum of the second luminescent material, which led to the completion of the present invention.
Furthermore, as phosphor of the second luminescent material was used a phosphor which had been subjected to heat treatment by microwave irradiation at the time of its synthesis. The light emitting device based on this phosphor was found to show an excellent color rendering hitherto unknown and, thus, the present invention was completed.

The subject matter of the present invention consists in a light emitting device comprising the first luminescent material, and the second luminescent material absorbing light from said first luminescent material and emitting light, wherein the absorption spectrum of the phosphor included in said second luminescent material satisfies the formula (1) below.

[mathematical formula 1]

$$1 \geq P(\lambda)_{min} / P(\lambda)_{max} \geq 0.3 \qquad (I)$$

(In the formula (I) above, $P(\lambda)$ indicates the intensity of the absorption spectrum at the wavelength $\lambda$, $P(\lambda)_{max}$ indicates the maximum value of $P(\lambda)$ in the range of 400 nm $\leq \lambda \leq$ 450 nm, and $P(\lambda)_{min}$ indicates the minimum value of $P(\lambda)$ in the range of 400 nm $\leq \lambda \leq$ 450 nm.)

Another subject matter of the present invention consists in a light emitting device comprising the first luminescent material, and the second luminescent material absorbing light from said first luminescent material and emitting light, wherein said second luminescent material contains a material belonging to the III - V group of the periodic table and the chromaticity coordinate of the luminescent color of the light emitted from said light-emitting device is in the area surrounded by the following 5 points of (X,Y) = (0.18, 0.30), (0.22, 0.50), (0.40, 0.40), (0.45, 0.30), and (0.22, 0.20).

Advantageous effect of the invention

According to the present invention, it is possible to provide a light emitting device in which either little fluctuation in emission characteristics with respect to time or little fluctuation of emission characteristics with respect to individual devices is assured. Besides, it is possible to provide a light emitting device with high efficiency, little burden on the environment and high color rendering.

Brief Description of the Drawings

[Fig. 1] Fig. 1 is an example of an absorption spectrum of the second luminescent material showing intense absorption in the range of $\lambda >$ 450 nm.
[Fig. 2] Fig. 2 is an example of an emission spectrum from the first luminescent material having high emission efficiency.
[Fig. 3] Fig.3 is a schematic perspective view illustrating positional relationship between the first luminescent material and the second luminescent material.
[Fig. 4] Fig. 4 is a schematic cross-sectional view illustrating one example of a light emitting device of the present invention.
[Fig. 5] Fig. 5 is a schematic cross-sectional view illustrating one example of a surface emitting device of the present invention.
[Fig. 6] Fig. 6 is an example of an absorption spectrum of the second luminescent material used in a light emitting device of the present invention.
[Fig. 7] Fig. 7 is an example of an emission spectrum of the second luminescent material used in a light emitting device of the present invention.

Explanation of Letters or Numerals

1    second luminescent material
2    surface emitting type GaN series LED
3    substrate
4    light emitting device
5    mount lead
6    inner lead
7    first luminescent material

8       resinous part containing the second luminescent material of the present invention.
9       electricity conducting wire
10      mold member

Best Mode for Carrying Out the Invention

As the first luminescent material can be cited solid light emitting elements such as light emitting diode (LED) or laser diode (LD). LED and LD are preferable because of their small consumption of electric power. Particularly preferable is LD.
When LED or LD is used as the first luminescent material, LED or LD (hereinafter referred to as "GaN series LED" or "GaN series LD" as appropriate) which usees GaN series compound semiconductor in the light emitting layer is preferable. This is because, in comparison with other LED or LD such as LED based on SiC, they have higher emission output and higher external quantum efficiency, and by combining with the second luminescent material, they make it possible to provide a light emitting device characterized by low electric power and high luminance. For example, at a current load of 20 mA, GaN series LED can usually emit light more than 100 times as intense as light from LED based on SiC.
GaN series compound semiconductor mentioned here indicates a semiconductor whose principal constituents are Ga atom and N atom.
It is preferable that a light emitting layer of GaN series LED or GaN series LD contains $Al_xGa_{1-x}N$, GaN or $In_xGa_{1-x}N$ because emission intensity of LED or LD is then high. Particularly preferable is $In_xGa_{1-x}N$. In this formula, x indicates an arbitrary real number satisfying 0<x<1 (hereinafter x indicates the same real number) . Of GaN series LD, those having a multiquantum well structure of $In_xGa_{1-x}N$ layer and GaN layer are preferable because of high emission intensity. On the other hand, regarding GaN series LED, it is preferable that the light emitting layer is doped with Zn or Si, because it is then easier to control emission characteristics such as emission intensity or wavelength distribution of emission spectrum.
GaN series LED usually has a light emitting layer, p layer, n layer, electrodes and substrate as its main constituents. In order to assure high emission efficiency, it is preferable to construct it as a heterostructure by sandwiching the light emitting layer with $Al_xGa_{1-x}N$ layers, GaN layers or $In_xGa_{1-x}N$ layer of n type and p type. For the same reason, it is more
preferable that the light emitting layer takes a quantum well structure.
Regarding the emission spectrum of the first luminescent material, the wavelength giving the highest emission intensity is preferably 350 nm or longer, more preferably 380 nm or longer, most preferably 400 nm or longer, and preferably 500 nm or shorter, more preferably 450 nm or shorter, most preferably 430 nm or shorter. The above wavelength range is preferable so that the chromaticity coordinate of the luminescent color of the light emitted from the light emitting device of the present invention can fall within the range specified in this invention, as will be described later. When 2 or more wavelengths give the highest emission intensity or emission intensity is similar in certain ranges, it is preferable that at least one of those wavelengths or one in that wavelength range falls within the above range. This is because, in using LED or LD, which has good emission efficiency, as the first luminescent material, selection of a wavelength giving the highest emission intensity, as described above, can further enhance the emission efficiency.

<second luminescent material>

The second luminescent material is a luminescent material which absorbs light from the first luminescent material and emits light, and contains a phosphor which absorbs light from the first luminescent material and gives rise to photoluminescence. Usually, peak wavelength of light from the first luminescent material and that from the second luminescent material are not the same, and the relationship between the two is not fixed. However, it is preferable that the peak wavelength of the second luminescent material is longer than that of the first luminescent material.
It is preferable that the absorption spectrum of the phosphor contained in the second luminescent material of the present invention has little fluctuation in intensity at the wavelength λ of 400 nm to 450 nm. Furthermore, it is preferable that the phosphor contained in the second luminescent materia satisfies the formula (I) below.
[mathematical formula 1]

$$1 \geq P(\lambda)_{min} / P(\lambda)_{max} \geq 0.3 \qquad (I)$$

(In the formula (I) above, P(λ) indicates the intensity of the absorption spectrum at the wavelength λ, $P(\lambda)_{max}$

indicates the maximum value of $P(\lambda)$ in the range of 400 nm $\leq \lambda \leq$ 450 nm, and $P(\lambda)_{min}$ indicates the minimum value of $P(\lambda)$ in the range of 400 nm $\leq \lambda \leq$ 450 nm.)

The ratio of $P(\lambda)_{min}$ / $P(\lambda)_{max}$ is preferably 0.5 or larger, more preferably 0.7 or larger and most preferably 0.8 or larger.

The reason is as follows.

The intensity of an emission spectrum of the first luminescent material with good emission efficiency is mainly distributed in the range of 400 nm $\leq \lambda \leq$ 450 nm. The statement that "intensity is mainly distributed in the range of 400 nm $\leq \lambda \leq$ 450 nm" means that 70 % or more, preferably 80 % or more, of the area of intensity is in the wavelength range between 400 nm and 450 nm. However, the emission spectrum of the first luminescent material may sometimes fluctuate with time, usually to the extent of $\pm$ 10 nm. Namely, an emission spectrum of the first luminescent material fluctuates with time along the wavelength ($\lambda$) axis to the extent of $\pm$ 10 nm. In addition to time-dependent fluctuation, there is also fluctuation due to inter-luminescent material difference of the first luminescent material. This has to be taken into account when mass producing light emitting devices. The fluctuation due to this inter-luminescent material difference is also to the extent of $\pm$ 10 nm. Therefore, it is desirable that the absorption spectrum of the second luminescent material fluctuates little in the range of 400 nm $\leq \lambda \leq$ 450 nm. In general, an emission spectrum of the first luminescent material shows a bell-shaped distribution around a peak wavelength. When the above fluctuation is large, absorption efficiency of the second luminescent material fluctuates considerably because of fluctuation of the emission spectrum along the wavelength axis due to the above-described time-dependent and/or luminescent material-dependent difference. Therefore, unless the fluctuation in intensity of the absorption spectrum of the phosphor of the second luminescent material in the range of 400 nm $\leq \lambda \leq$ 450 nm is within 30 % to 100 %, namely unless the minimum value is 30 % to 100 % of the maximum value, light absorption from the first luminescent material can not occur efficiently.

In order for the above $P(\lambda)_{min}$ / $P(\lambda)_{max}$ to satisfy the formula (I), the following methods can be adopted.

(1) Use as phosphor a substance whose end of the absorption spectrum (longest wavelength at which absorption intensity is zero) lies in the long wavelength region.

(2) Decrease the amount of impurities contained in the phosphor.

(3) Decrease the deviation in composition (for example, $In_{0.3}Ga_{0.2}P_{0.5}$ in some area and $In_{0.1}Ga_{0.7}P_{0.2}$ in other area) of compounds in the phosphor.

(4) Reduce the ratio of crystal defect area (for example, area in which atoms are displaced from their original sites) in the phosphor crystal.

In particular, it is preferable to follow the method (1) above and to select as phosphor a substance whose end of the absorption spectrum lies in the long wavelength region. No concrete limitation is imposed on the end of the absorption spectrum insofar as the advantage of the present invention is not significantly impaired. It is preferably 400 nm or longer, more preferably 450 nm or longer, still more preferably 500 nm or longer, most preferably 600 nm or longer. It is usually 2 $\mu$m or shorter. Furthermore, in order to select a substance whose end of the absorption spectrum lies in the long wavelength region, it is preferable to use a material with a minimum of energy gap as phosphor. For that purpose, III-V group compounds are suitable as phosphor. InGaP series substances are particularly preferable.

In executing the above method (2), it is preferable to maintain the level of impurities in the phosphor at 30 weight % or lower. More preferably, it is 10 weight % or lower and most preferably, it is 1 weight % or lower. It is usually 0.0001 weight % or higher.

In the method (3) above, deviation of composition ratio of each atom in the phosphor from the average value is preferably 50 % or less, more preferably 10 % or less. It is usually 0.1 % or more. The average value of the composition ratio of each atom can be obtained by inductively-coupled plasma emission spectrometry (IPC). More concretely, in order to obtain deviation of composition ratio of each atom in the phosphor from the average value, composition ratio of each atom can be measured for any given 100 areas of 10 Å x 10 Å by means of electron beam microanalyzer (EPMA) and the average value is obtained, and the deviation from the average value is then calculated for each area.

In the method (4) above, the ratio of the area of crystal defect in the phosphor is preferably 50 % or less of the theoretical value, more preferably 30 % or less. It is usually 0.1 % or more. The ratio of crystal defect can be measured by determining the site of each atom in any selected area of 100 Å x 100 Å by means of X ray absorption fine structure analysis (XAFS) and by analyzing the site data against the theoretical site data.

Two or more methods of (1) to (4) above can be used in any combination.

It is desirable that the intensity $P(\lambda)$ of the absorption spectrum of the phosphor contained in the second luminescent material in the wavelength range of over 450 nm is less than $P(\lambda)_{max}$ mentioned above. The reason is as follows.

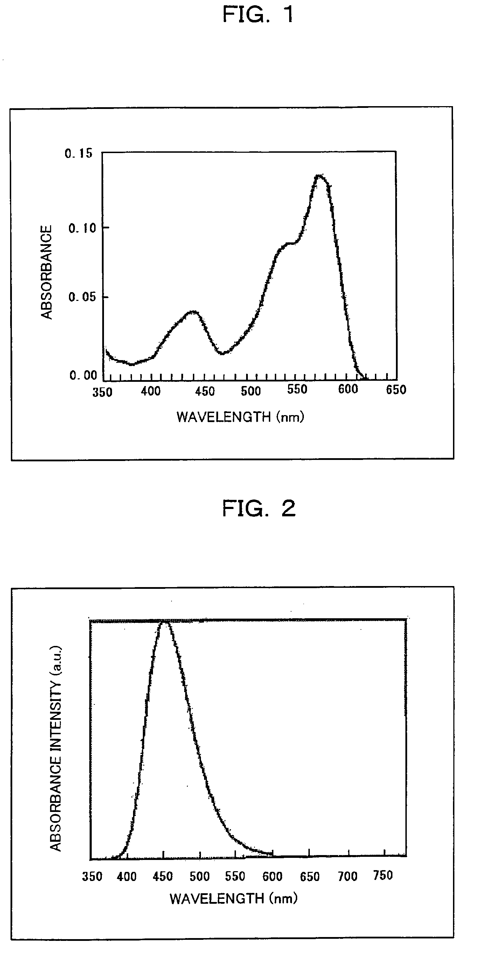

When some $P(\lambda)$ value in the range of $\lambda > 450$ nm is larger than the maximum value (namely, $P(\lambda)_{max}$) in the range of 400 nm $\leq \lambda \leq$ 450 nm, the spectral weight in the range of 400 nm $\leq \lambda \leq$ 450 nm is trimmed, the trimmed portion being added to the range of $\lambda > 450$ nm accordingly. Fig. 1 shows one example of such an absorption spectrum. In this case, the intensity of the absorption spectrum of the second luminescent material is low in the range of 400 nm $\leq \lambda \leq$ 450 nm,

where the light emitting spectrum of the preferably usable light emitting diode is predominant (Fig. 2 shows an emission spectrum of the first luminescent material when LED with an emission wavelength of 450 nm was used as the first luminescent material). As a result, the second luminescent material can not absorb light from the light emitting diode efficiently.

Furthermore, it is preferable that the intensity at any wavelength $\lambda$ longer than 450 nm is weaker than that of any wavelength $\lambda$ in the range 400 nm to 450 nm. In other words, it is preferable that the intensity $P(\lambda)$ of the absorption spectrum in the range of over 450 nm is less than $P(\lambda)_{min}$ mentioned above. This is because, when there is strong absorption intensity in the range of over 450 nm, absorption spectrum of sufficiently strong intensity can not be generally obtained in the range of 400 nm $\leq \lambda \leq$ 450 nm, where the first luminescent material with high emission efficiency exhibits an emission spectrum.

The second luminescent material of the present invention is a luminescent material which absorbs light from the first luminescent material and emits light, and contains a phosphor which absorbs light from the first luminescent material and emits light. There is no special limitation on the material used for the phosphor and the phosphor can be either an inorganic compound or an organic compound. Preferable is an inorganic compound, particularly III - V group compound of the periodic table.

By III - V group compound is meant compound which is substantially composed of at least one element belonging to group III of the long periodic table such as B, Al, Ga, In or Ti, and at least one element belonging to group V of the long periodic table such as N, P, As, Sb or Bi. "Substantially composed of at least one element belonging to group III of the long periodic table and at least one element belonging to group V of the long periodic table" means that it is mainly composed of group III element and group V element but may contain a minute amount of component, such as impurities insofar as the performance of the luminescent material is not significantly impaired.

As III - V group compounds can be cited, for example, BN series compounds, AlN series compounds, GaN series compounds, GaP series compounds, InP series compounds, InGaN series compounds and InGaP series compounds.

The meaning of "InGaP series compounds" or "BN series compounds" in this context is as follows. For example, "InGaP series compounds" are compounds which contain at least three elements of In, Ga and P and have a unique and specific crystal structure. Crystal structure means a structure having a periodic atom arrangement such as zinc blende structure or wurtzite structure. A part of at least one of the In, Ga and P sites may be replaced by other elements.

When the replacement occurs, it is preferable that the replacement for In or Ga site is by III group element, and that for P site is by V group element. It is also preferable that a replaced element and a replacing element have the same ionic valency so that the crystal structure is maintained easily because of equal electron charge distribution. Furthermore, the III - V group compound may be accompanied by another impurity element penetrating their sites insofar as their characteristics are not significantly impaired. They may have crystal defect or dislocation. As elements that can be contained in the phosphor of the present invention can be cited one or more element such as H, F, O or Al.

More preferable as phosphors contained in the second luminescent material are InP series compounds and InGaP series compounds, because they emit light with good color rendering when combined with the first luminescent material. InGaP series is particularly preferable.

It is preferable that InP series compounds have a composition ratio of InP. In this series, a part of either In sites or P sites may be replaced with other elements.

On the other hand, it is preferable that InGaP series compounds have a composition ratio described in the formula (II) below.

$$(In_yGa_{1-y})_zP_{1-z} \qquad (II)$$

In the formula (II) above, y and z are an arbitrary real number satisfying $0<y\leq1$ and $0\leq z<1$. Preferably, they are a real number satisfying $0<y<1$ and $0<z<1$. That y and z are in the range described above means, in the technical sense, that these ultrafine particles consist of ternary compound semiconductors which are characterized in that a part of In in the InP crystal lattice is replaced with Ga, or a part of Ga in the GaP crystal lattice is replaced with In. From the standpoint of quantum yield of light emission, the preferable range of y is $0.9 \leq y\leq1$ and that for z is z=0. More preferably, the range is $0.9\leq y\leq1$ and z=0.

Furthermore, a part of at least one of In, Ga and P sites may be replaced with other elements. As crystal structure of InGaP series compound, preferable is a zinc blende structure.

Furthermore, the phosphor may consist of particles of core shell structure. The core shell structure here indicates particles having inner core (core) and outer shell (shell). By assuming the core shell structure, it is possible to modify the physical and chemical characteristics of the particles in a desired way.

In this case, the phosphor may be contained either in the inner core or in the outer shell of the core shell structure. It is preferable that it is contained in the inner core.

The inner core and outer shell of the core shell structure may be composed of more than one kind of

materials. The shell may be more than one. As materials constituting the outer shell, preferable are one or more than one kind of III - V group compound semiconductor, II - VI group compound semiconductor or metal oxide. Particularly preferable are one or more than one kind of InP, BN, BAs, GaN, ZnO, ZnS, ZnSe, CdS, CdSe, MgS, MgSe and $SiO_2$. Furthermore, phosphors may be contained in both of the inner core and outer shell, using two or more kinds of phosphors (for example, two or more kinds of III - V group compounds).
The material in the outer shell, however, has to be different from that in the inner core.

The phosphor contained in the second luminescent material may be composed of single phosphor or more than one kind of phosphor. Furthermore, particles of the said phosphor may contain crystal defect or dislocation, or regional heterogeneity of the composition insofar as they do not impair its characteristics. They may contain impurities to the extent not impairing its characteristics. They may be single crystalline or polycrystalline.

Average particle diameter of the phosphor of the present invention is usually 0.5 nm or larger, preferably 1 nm or larger, more preferably 2 nm or larger, and usually 10 $\mu$m or smaller, preferably 1 $\mu$m or smaller, more preferably 100 nm or smaller, still more preferably 20 nm or smaller, still more preferably 12 nm or smaller, most preferably 10 nm or smaller. Average particle diameter indicates number average particle diameter. When the average particle diameter is too small, inactivation due to non-radiation caused by low crystallinity of the phosphor is liable to occur, leading possibly to decrease in intrinsic quantum efficiency and, as a result, decrease in light emission efficiency. When the average particle diameter is too large, the effect of increase in state density due to quantum effect becomes small, leading to inadequate absorption efficiency and decrease in light emission efficiency.

Average particle diameter and its standard deviation are determined by means of analysis of the image obtained by using transmission electron microscopy (TEM).
Because of this, it is possible to secure excellent light emission stability with respect to time, when a light emitting device was constituted in combination with the first luminescent material.

It is possible to make the phosphor of the present invention emit a spectrum of light having a narrow band by narrowing the particle diameter distribution. An emission spectrum with a narrow band described here indicates an emission spectrum having a narrow half bandwidth. The standard deviation of particle diameter of the present invention is preferably 10 % or less, more preferably 5 % or less. No particular limitation exists on the lower limit of the distribution of particle diameter. The standard deviation thereof is usually 0.001 % or more. When the particle diameter distribution of the phosphor is outside the above standard deviation range, narrowing of the emission spectrum intended is not adequate, resulting in poor purity in color.

The standard deviation ($\sigma$) referred to here is obtained as follows. Average particle diameter ($d$) is subtracted from each particle diameter ($di$) of the phosphor as measured from TEM photos. The value obtained was squared and the sum of all these squares was divided by the number of particles ($n$). The square root of this divided value was the standard deviation. The half
bandwidth was defined as follows. An absorbance at the peak wavelength was normalized to 1. The value of peak wavelength was subtracted from the value of wavelength giving an absorbance of 0.5 and being higher than the peak wavelength, and the value obtained was doubled to give half bandwidth.
Average particle diameter and standard deviation described above can be obtained by actual measurement from TEM photos but can also be obtained using image analyzing and processing equipment or the like.

It is possible to control the peak wavelength of the emission spectrum of the second light generated by the phosphor of the present invention by regulating its particle diameter. For example, in order to generate red light with emission wavelength of 590 nm to 650 nm, the particle diameter d of the said phosphor should be adjusted in the range of 4 nm < d < 6 nm. In order to generate green light with emission wavelength of 520 nm to 570 nm, the particle diameter d of the said phosphor should be adjusted in the range of 1.5 nm < d < 2.8 nm.

The quantum yield of the phosphor of the present invention is usually 40 % or higher, preferably 45 % or higher, more preferably 50 % or higher. When the yield is below this limit, it is necessary to increase the intensity of the exciting light source in order to assure practically sufficient brightness, which may cause an increase in consumption of electric power of the light emitting device. There is no upper limit in the yield. Theoretically, it is 100 % or less.

Processes used to increase the quantum yield of the phosphor include etching by fluorine compound, formation into a core shell of the phosphor, synthesis of the phosphor using microwave and covering the surface of the phosphor by organic materials. Of these processes, etching by fluorine compound is usually used in order to increase the quantum yield of luminance of the ultrafine particles of the phosphor consisting of III - V group material.

Etching is performed by adding a solution containing fluorine-compound ions to a phosphor-containing solution and irradiating with ultraviolet / visible light under stirring (Reference: Talapin, D.V., et al., J. Phys. Chem. B 2002, 106, pp. 12659-12663). This process is called photoetching. After the solution containing fluorine-compound ions is added to the phosphor-containing solution, quantum yield of the phosphor increases with time through stirring and light irradiation. In general, use of a dilute fluoride ion solution requires a longer reaction time to increase quantum yield. On the other hand, an increase in concentration of a fluoride ion solution leads to a faster increase in quantum yield. As examples of fluoride-ion containing compounds used for this purpose can be cited HF, $NH_4F$, $(CH_3)_4NF$, $(C_4H_9)_4NF$, and so on.

Quantum yield referred to in this specification means relative quantum yield and is measured as follows. Ethanol solution of rhodamine 6G is prepared first as reference solution. The concentration is adjusted to give an absorbance of about 0.1 at wavelength of 440 nm. The fluorescence spectrum of this solution is measured at an excitation wavelength of 440 nm. A solution of the phosphor is then prepared so that the absorbance of this solution at wavelength of 440 nm is similar to the absorbance of the reference solution at wavelength of 440 nm. The fluorescence spectrum of this solution of the phosphor is then measured under the same condition as that for the reference solution. Relative quantum yield $\phi_{em}$ is calculated according to the formula (III) below.

$$[mathematical \ formula \ 3]$$

$$\phi_{em} = \phi'_{em} \ (I/I') \ (A'/A) \ (n/n')^2$$

$$(III)$$

In the above formula (III), I represents an integrated area of the emission peak of the sample (phosphor solution) and I' represents an integrated area of the emission peak of the reference solution. A represents an absorbance of the sample (phosphor solution) at the excitation wavelength (440 nm) and A' represents an absorbance of the reference solution at the excitation wavelength (440 nm). $n$ and $n'$ represent refractive index of the solvent of the sample (phosphor solution) and the solvent of the reference solution, respectively. $\phi'_{em}$ indicates quantum efficiency of rhodamine 6G (0.95).

The phosphor of the present invention may be accompanied by an organic compound on its surface. The statement "accompanied by an organic compound on its surface" indicates that some organic compound is bound to the surface of the phosphor and kept retained there. The mode of binding between the organic compound on the surface and the phosphor is not limited to a special one. Examples include relatively strong chemical bond such as coordinate bond, covalent bond or ionic bond, and relatively weak reversible interaction such as van der Waals forces, hydrogen bond, hydrophobic-hydrophobic interaction, affinity due to entwinement of molecular chains. Either one kind or more than one kind of organic compounds may be bound to the surface. No particular limitation is imposed on the kind of organic compounds. Examples include trialkyl phosphines, trialkyl phosphineoxides, alkane sulfonates, alkane phosphonates, alkyl amines, dialkyl sulfoxides, dialkyl ethers, fatty acids, alkenes, alkynes, and so on.

Dispersibility of phosphors in organic solvents or binder resins increases as a result of binding of organic compounds on its surface.

<Method of synthesis>

For the preparation of phosphor particles of the present invention, it is desirable to use a heat-reaction vessel to which heat can be applied. By using such a heat-reaction vessel, it is possible to maintain the temperature in the vessel higher than that of the room temperature. If the reaction system is a closed one, it is possible to shut down the transfer of materials into and out of the heat-reaction vessel. In the reaction vessel are usually placed more than one kind of starting materials (precursor of phosphor) and solvent. In some cases, only starting materials are placed. As starting materials, materials known to be used for the synthesis of the desired phosphor (compounds of metal element constituting the phosphor) are used so as to give an approximate composition ratio desired.

Mixing of starting materials and / or solvent or mixing of more than one starting materials is usually performed at temperatures of - 30°C or higher and 100°C or lower. It is preferable to perform the mixing at the same temperature as outside environment (room

temperature) because of ease of temperature control. In this case, the temperature is usually 0°C or higher and 40°C or lower. The temperature of the heat-reaction vessel is measured with such devices as thermometer, pyrometer or thermocouple, and controlled.

The manufacturing process of phosphors in the heat-reaction vessel usually consists of one or more of the following processes: (1) heating, (2) heat retaining, (3) cooling. Heat retaining here indicates retaining of temperature in the heat-reaction vessel at a certain level, and it is usually higher than the outside environment temperature (room temperature).

Heat can be applied to the reaction vessel by means of a heat source such as oil bath, mantle heater or flame burner, or by means of microwave irradiation. In particular, adoption of microwave irradiation may make it possible to adjust the intensity of light emitted from phosphor particles in the range of formula (1)

described above. In addition to microwave irradiation, other methods such as oil bath, mantle heater or flame burner may be combined as appropriate.

The peak wavelength of microwave used for irradiation is preferably 1 GHz or longer, more preferably 2 GHz or longer, most preferably 2.4 GHz or longer. It is preferably 10 GHz or lower, more preferably 3 GHz or shorter, most preferably 2.5 GHz or shorter. It is preferable to use a microwave with a sharp wavelength spectrum, particularly to use a microwave of a single mode. In case electric power of the microwave is too strong, regulation of the synthetic reaction of the phosphor is sometimes difficult. In case electric power of the microwave is too weak, the synthesis reaction may not proceed as planned. It is preferably set at 100 W ~ 30 kW. Further, it is preferable that it is so arranged that the ambient gas of the reaction is allowed to flow continuously in the reaction vessel at the time of microwave irradiation. Heating temperature is usually 50°C or higher, preferably 100°C or higher, more preferably 200°C or higher. It is usually 1000°C or lower, preferably 500°C or lower, more preferably 300°C or lower.

In the synthesis of such phosphors, the value of particle diameter distribution of the phosphors obtained can be favorably controlled by adjusting properly heating rate and cooling rate in the reaction vessel. For example, in the heating reaction vessel, the temperature is raised sharply and lowered sharply. More concretely, it is preferable that the heating rate is 20°C / minute or higher, and cooling rate is 50°C /minute or higher.

It is also possible to control the particle diameter of the phosphor obtained by controlling the concentration of the precursor of the phosphor in the reaction solution. In order to produce larger particles, a multi-injection method can be applied. By this multi-injection method, the precursor of the phosphor is added further to the reaction vessel after the synthesis of the phosphor according to the method mentioned above and this process is repeated as is considered necessary. For example, in the second synthetic reaction, it is possible to obtain superfine particles of larger particle diameter, of the phosphor, than those obtained in the first synthetic reaction. Thus, it is possible to control the particle diameter through this multi-injection process.

Distribution of particle diameter (standard deviation of particle diameter distribution) of the phosphor of the present invention can be controlled by selecting microwave frequency appropriately.

<Constitution of luminescent material>

In the present invention, it is preferable to use a surface-emitting type luminescent material, especially surface-emitting type GaN series LD, as the first luminescent material. Emission efficiency of the entire light emitting device is then increased. In this context, a surface-emitting type luminescent material is a luminescent material which emits strong light in the direction perpendicular to the membrane. In a surface-emitting type GaN series LD, it has been successful to lead light more in the direction perpendicular to the surface rather than towards the edge, by controlling crystal growth of the light emitting layer and by appropriately placing a reflection layer and so on. In the use of a surface-emitting type luminescent material, a light emitting cross sectional area per unit amount of light emitting can be made larger in comparison with a type which permits light emitting from the edge. As a result, when its light is received by the phosphor of the second luminescent material, illumination area per unit amount of light becomes large, leading to increased illumination efficiency. It is then possible to secure intensive light emission from the phosphor. When a surface-emitting type luminescent material is used as the first luminescent material, it is preferable to shape the second luminescent material as membrane. Cross sectional area of light from a surface emitting type luminescent material is sufficiently large and, therefore, if the second luminescent material is shaped to be a membrane parallel to the cross sectional area of light from the surface emitting type luminescent material towards the phosphor from the first luminescent material per unit amount of phosphor can be made large, leading to more intensive light emitting from the phosphor.

In case the first luminescent material is of surface emitting type and the second luminescent material is of membrane type, it is preferable that the light emitting surface of the first luminescent material is in direct contact with the membrane of the second luminescent material. "Direct contact" here means that the first luminescent material and the second luminescent material are in contact with each other with no other material, like gas such as air, or various kinds of liquid, in-between. By this arrangement, it is possible to prevent light emitted from the first luminescent material from going outside by reflection at the membrane surface of the second luminescent material (light loss), and emission efficiency of the device as a whole becomes higher.

In the following, examples of a light emitting device of the present invention will be explained by referring to drawings.

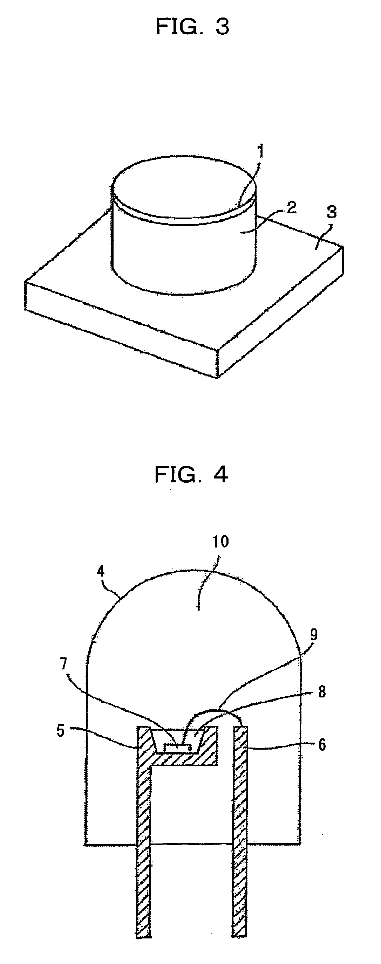

Fig. 3 shows a schematic perspective view illustrating positional relationship between the first luminescent material and the second luminescent material in one embodiment of a light emitting device of the present invention. In Fig. 3, 1, 2 and 3 indicate second luminescent material, the first luminescent material (for example, surface-emitting type GaN series LED) and substrate, respectively. It is preferable that LED and the second luminescent material are in contact with each other because loss in luminous flux is then small. In order to effect this direct contact, LED and the second luminescent material are prepared independently first and the surfaces of these two are made to contact by means of adhesives or by other means. Or the second luminescent material is formed as membrane or molded on the light emitting surface of the LED.

It is preferable to use, as the second luminescent material, powder of phosphor dispersed in resin. Light from the first and second luminescent materials are usually emitted in various directions. By using the second luminescent material dispersed in resin, a part of the light is reflected when it leaves the resin and it is then possible to control the light so that it is emitted in an aligned direction. Also, the total irradiation area of light from the first luminescent material against the second luminescent material is made larger, and therefore light emission intensity from the second luminescent material can be made larger. As resins can be used epoxy resin, polyvinyl resin, polyethylene resin, polypropylene resin, polyester resin, and so on. Epoxy resin is particularly preferable because of good dispersibility of the powder of phosphors.

When the powder of phosphors is dispersed in resin, the weight ratio of the phosphor powder in the mixture of phosphor powder and resin is usually 1 % or higher, preferably 10 % or higher, more preferably 20 % or higher, still more preferably 30 % or higher. It is usually 95 % or lower, preferably 90 % or lower, more preferably 80 % or lower. When the weight ratio of phosphors is too high, emission efficiency may decrease because of aggregation of the phosphor powder. In case the weight ratio is too low, emission efficiency may also decrease as a result of absorption or scattering of light caused by resin.

Fig. 4 shows a schematic cross-sectional view of another example of a light emitting device of the present invention.

The light emitting device shown in Fig. 4 is a shell type. In a cup (5) formed in the upper part of the mount lead, the first luminescent material (7) is placed as covered by the resinous part (8) containing phosphors. In other words, the second luminescent material is prepared on the first luminescent material. The second luminescent material is prepared by mixing and dispersing a phosphor in a binder such as epoxy resin or acrylic resin, and pouring the mixture into the cup.

In Fig. 4, the first luminescent material (7) and mount lead (5), as well as the first luminescent material (7) and inner lead (6), are connected via electricity conducting wire (9) and the entire part is covered and protected by mold member (10) such as epoxy resin.

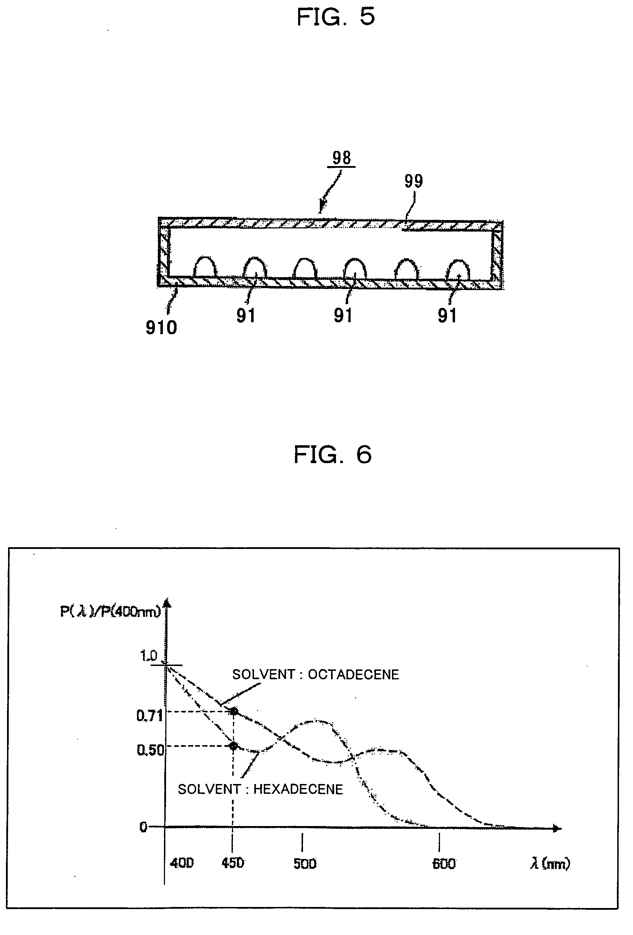

An example of a surface emitting lighting system (98) incorporating this light emitting element is shown in Fig. 5. A number of light emitting devices (91) are installed on the basal plane of a rectangular storage case (910), the inner surface of which is a white smooth surface permitting no light transmission. On the outside surface of the light emitting device are installed a power source and circuit (not shown in the figure.) for the operation of the light emitting element.

A diffusion plate made of, for example, a milky white acrylic plate (99) is fixed at a position corresponding to the lid of the storage case in order to secure homogenization of light emission. With this surface emitting lighting system, the first luminescent material is allowed to emit light by application of voltage to the first luminescent material of the light emitting element. A part of the light emitted is absorbed by the phosphor in the resinous part containing the phosphor of the second luminescent material. The phosphor described above absorbs a part of the light emitted from the first luminescent material and emits light having a spectrum different from that of the absorbed light. This light and unabsorbed light from the first luminescent material such as blue light are mixed to give light with a high color rendering, which penetrates the diffusion plate and is released in the upward direction of the figure. Illumination with homogeneous brightness is obtained in the diffusion plate plane of the storage case.

<Chromaticity coordinate of the luminescent color of the light emitted from the light emitting device>

In a light emitting device of the present invention, it is desirable to mix light from the first luminescent material and that from the second luminescent material and to make light emitted from the light emitting device white in color. By making generated light white in color, a color rendering of an object irradiated by the light emitting device can be improved. This is particularly important when the light emitting device of the present invention is used as a component of lighting system.

It is desirable that the chromaticity coordinate of the luminescent color of the light emitted by a light emitting device of the present invention is located in the area surrounded by 5 points (borderline inclusive) of $(X,Y) = (0.18, 0.30)$, $(0.22, 0.50)$, $(0.40. 0.40)$, $(0.45, 0.30)$ and $(0.22, 0.20)$.

The chromaticity coordinate here indicates an XY coordinate value based on spectral tristimulus value, as defined by the Commission Internationale de l'Eclairage (CIE) in 1931. When the chromaticity coordinate of the luminescent color of the light emitted from the light emitting device falls within the above range, light reflected from an object irradiated by that light has a spectrum resembling the color of an object irradiated by solar light (daylight light). Accordingly, a light emitting device with a high color rendering can be realized.

It is further desirable that the chromaticity coordinate of the luminescent color of the light emitted by the light emitting device is located in the area surrounded by 5 points (borderline inclusive) of $(X, Y) = (0.28, 0.26)$, $(0.25, 0.35)$, $(0.28. 0.40)$, $(0. 38, 0.38)$ and $(0.38, 0.31)$.

In order for the luminescent color of the light emitting device to have the chromaticity coordinate as desired above, it is preferable to use the III - V group material as phosphor contained in the second luminescent material, to synthesize the III - V group material in a heat-reaction vessel, in particular to use the III - V group material obtained by processes including a heating process of microwave irradiation to sources of the III - V group material.

Furthermore, it is possible to arrange in such a way that the emitted light has a desired chromaticity coordinate mentioned above by mixing more than one kind of phosphors belonging to III - V group material. More than one kind of phosphors referred to here indicate that they are different in composition or different in particle diameter, if similar in composition. The term "more than one kind" implies that the parameter showing the difference (composition ratio (such as x in $In_xGa_{1-x}$), particle diameter etc.) has its own distribution(or variance).

A light emitting device of the present invention may contain an additional luminescent material in addition to the first luminescent material and the second luminescent material. For example, the third luminescent material, which absorbs light from the second luminescent material and release visible light, may be used to constitute a light emitting device emitting mixed light from the first, second and third luminescent materials. Or the third luminescent material, which absorbs light from the first and/or second luminescent material and emits visible light, may be used to constitute a light emitting device emitting mixed light from the first, second and third luminescent materials.

A light emitting device of the present invention may be fitted with a color filter.

Example

The present invention will be explained in more detail below by referring to examples. It is to be understood that the present invention is by no means limited to these examples.

Described below is an example of the synthesis of an InGaP series compound as phosphor. Unless otherwise indicated, commercially available reagents were used without further purification. The instruments used were as indicated below.

(Experimental instrument)

Synthesis equipment using microwave:

DISCOVER system of CEM Corporation Co. Source of constant electric power and pulse electric power: MILESTONE ETHOS system of Milestone Corporation Co.

Plasma emission spectrometry instrument:

Inductively-Coupled Plasma Emission Spectrometer [JY38S] of JOBIN YVON Co. UV / V Absorption spectrometer: CARY 50 BIO WIKN UV Spectrometer

Photoluminescence spectrometry instrument:

CARY ECLIPSE Fluorescence Spectrometer

X ray diffraction instrument:

SCINTAG X2 powder diffractometer

Transmission electron microscope (TEM):

JEOL 2010 Transmission Electron Microscope

DISCOVER system was equipped with a small reaction vessel (10 ml) having an aluminum cap for use at high pressure and fitted with a Teflon (registered trade mark) diaphragm. All glassware was dried before use. Care was taken so that chemical reagents used as starting materials did not come into contact with air.

(Example 1) Indium acetate (In(OAc)), gallium acetylacetonate complex (Ga (acac)) and palmitic acid were dissolved in hexadecene maintained at 100 °C to prepare a positive ion solution of 15.6 mM. The number of positive ions in this case is defined as the sum of Ga ions and In ions. The ratio of mixing was adjusted to satisfy the following equations (1) and (2).

```
    (1) Number of Ga atoms / (number of In atoms + number
 of Ga atoms) = 0.095
```

```
(2) Number of palmitic acid molecules / (number
of Ga atoms + number of In atoms) = 3
```

While this solution was maintained at the above temperature, it was degassed in vacuo for 1 hour and purged with Ar gas 3 times.

Next, 86.1 mM solution of $P(SiMe_3)_3$(Me indicates methyl group) was prepared with hexadecene as solvent. In this manner were prepared the precursor substances of the reaction, indium gallium salt of palmitic acid ($CH_3(CH_2)_{14}COO$ (In,Ga)) and $P(SiMe_3)_3$. For the method of the above synthesis, reference can be made to Nano Lett. 2, 107 (2002).

Next, indium gallium salt of palmitic acid and $P(SiMe_3)_3$ were mixed in hexadecene so that the ratio of the total number of positive ions (sum of indium ions and gallium ions) and the number of negative ions (phosphate ions) was 2: 1. The total volume of the solution was 5 mL and the whole solution was maintained at 50 °C.

The solution in a reaction vessel was then subjected to electromagnetic wave irradiation (frequency: 2.45 GHz) at 300 W until the temperature of the solution reached 280 °C. After the temperature reached 280 °C, power intensity of electromagnetic wave irradiation was lowered to 280 W and maintained at that intensity. The temperature of the reaction solution and the intensity of electromagnetic wave irradiation were maintained at the same level for 15 minutes and then the solution was cooled rapidly. Particles of InGaP series compound with a particle diameter of 2. 3 nm were thus obtained. Crystals of InGaP compound particles obtained had a zinc blende structure with particle diameter distribution (standard deviation of particle diameter distribution) of 5 %. The composition of particles of this InGaP compound was confirmed to be $(In_{0.95}Ga_{0.05})P$ by plasma emission spectrometry.

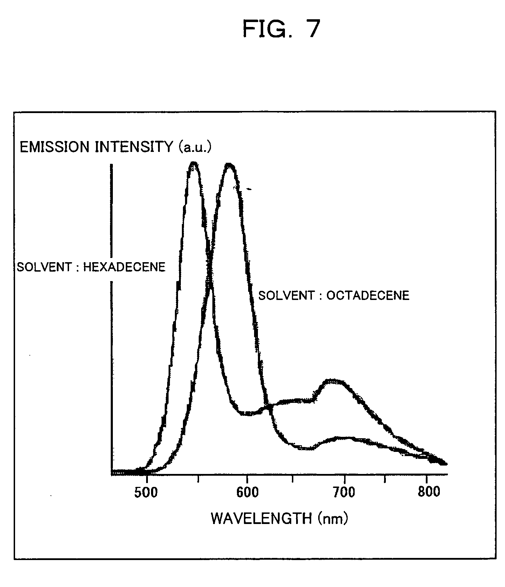

An absorption spectrum of this InGaP particle was measured using a UV / V absorption spectrophotometer. The result is shown in Fig. 6 (see data for "solvent : hexadecene") . The $\lambda$ giving $P(\lambda)_{max}$ was 400 nm and that giving $P(\lambda)_{min}$ was 450 nm. The emission spectrum was measured using a photoluminescence spectrometer. The result is shown in Fig. 7 (see data for "solvent : hexadecene"). The emission spectrum is shaped like a normal distribution curve with its peak wavelength at 560 nm and half height width of 40 nm. Thus, particles with $P(\lambda)_{min}/P(\lambda)_{max} = 0.50$ were obtained.

Particles of InGaP series compound (III - V group material) thus obtained was combined with an inorganic LED, whose emission peak is 400 nm, to constitute a light emitting device. The light emitting device obtained showed an emission spectrum whose chromaticity coordinate was (X,Y) = (0.33, 0.34).

InGaP particles synthesized (1 mL) was measured and transferred to a glass vial, followed by addition of 4 mL of toluene. Acetone (20 mL) was added and precipitate formed was recovered by centrifugation. The precipitate obtained was dissolved again in toluene (5 mL). To this solution was added 20 $\mu$L of 10 weight % HF in water · butanol, which was prepared by diluting 48 weight % HF aqueous solution with butanol, and the mixture was irradiated under stirring with 365 nm UV light for one hour using handy type UV irradiation apparatus. After the reaction, methanol (20 mL) was added to the solution and the precipitate obtained was recovered by centrifugation. To the precipitate was added toluene to prepare a solution to be used for quantum yield measurement of the predetermined density. The quantum yield was 70 %.

<Stability of emission spectrum>

Similar synthesis experiments were repeated 5 times and emission spectrum was measured each time. The fluctuation of peak wavelength of the emission spectrum was in the range of 560 nm $\pm$ 3 nm, indicating excellent reproducibility.

(Example 2)

The same procedure as Example 1 was followed except that octadecene, not hexadecene, was used as solvent when indium gallium palmitate was mixed with $P(SiMe_3)_3$-Particles of InGaP series compound with a particle diameter of 4.3 nm were obtained.

Crystals of this InGaP series compound had a zinc blende structure, with its particle diameter distribution (standard deviation of particle diameter) of 5%.

The composition of this InGaP series compound was confirmed to be $(In_{0.94}Ga_{0.06})P$ by plasma emission spectrometry.

An absorption spectrum of this particle was measured using a UV / V absorption spectrophotometer. The result is shown in Fig. 6 (see data for "solvent : octadecene") . The $\lambda$ giving $P(\lambda)_{max}$ was 400 nm and that giving $P(\lambda)_{min}$ was 450 nm. The emission spectrum was measured using a photoluminescence spectrometer. The result is shown in Fig. 7 (see data for "solvent : octadecene"). The emission spectrum is shaped like a normal distribution curve with its peak wavelength at 600 nm and half height width of 50 nm. The excitation wavelength at the time of measurement of emission spectrum was set at 400 nm. Thus, particles with $P(\lambda)_{min}/P(\lambda)_{max}$ = 0.71 were obtained.

Particles of InGaP series compound (III - V group material) thus obtained was combined with an inorganic LED, whose emission peak is 400 nm, to constitute a light emitting device. The light emitting device obtained showed an emission spectrum whose chromaticity coordinate was (X,Y) = (0.40, 0.39).

Particles of InGaP obtained were subjected to etching procedure in the manner similar to that of Example 1, and its quantum yield was measured. The yield was 50 %.

<Stability of emission spectrum>

Similar synthesis experiments were repeated 5 times and the emission spectrum was measured each time. The peak wavelength of the spectrum was in the range of 600 nm $\pm$ 4 nm, indicating excellent reproducibility.

For example, in a light emitting device in which GaN series LD is used as the first luminescent material, and particles of phosphor of InGaP series compound, synthesized by the method described in the above Example and mixed into resin, are used as the second luminescent material, the absorption spectrum of the phosphor contained in the second luminescent material satisfies $1 \geq P(\lambda)_{min}/P(\lambda)_{max} \geq 0.3$. Then, it is possible to suppress the fluctuation in emission characteristics of the second luminescent material in case of time-dependent fluctuation in emission wavelength of the first luminescent material. Also, when an inter-device difference occurs in emission spectrum of the first luminescent material, fluctuation in emission characteristics of the second luminescent material can be suppressed. Therefore, it is possible to provide a light emitting device in which at least either emission stability with respect to time or emission stability with respect to inter-device fluctuation is improved.

Industrial Applicability

1 A light emitting device of the present invention can be used, for example, as light source of indoor lighting system, backlight for image display unit such as color liquid crystal display and light source of traffic signal.

The present invention has been explained in detail above with reference to specific embodiments. However, it is evident to those skilled in the art that various modifications can be added thereto without departing from the intention and the scope of the present invention.

The present application is based on the descriptions of Japanese Patent Application No. 2004-340645, filed on November 25, 2004, Japanese Patent Application No. 2004-340647, filed on November 25, 2004, Japanese Patent Application No. 2005-340387, filed on November 25, 2005 and Japanese Patent Application No. 2005-340388, filed on November 25, 2005, and their entireties are incorporated herewith by reference.

**Claims**

1. A light emitting device comprising the first luminescent material, and the second luminescent material absorbing light from said first luminescent material and emitting light, wherein the absorption spectrum of the phosphor included in said second luminescent material satisfies the formula (1) below.

$$[\text{mathematical formula 1}]$$

$$1 \geq P(\lambda)_{min} / P(\lambda)_{max} \geq 0.3 \qquad (I)$$

(In the formula (I) above, $P(\lambda)$ indicates the intensity of the absorption spectrum at the wavelength $\lambda$, $P(\lambda)_{max}$ indicates the maximum value of $P(\lambda)$ in the range of 400 nm $\leq \lambda \leq$ 450 nm, and $P(\lambda)_{min}$ indicates the minimum value of $P(\lambda)$ in the range of 400 nm $\leq \lambda \leq$ 450 nm.)

2. A light-emitting device as defined in claim 1, wherein the chromaticity coordinate of the luminescent color of the light emitted from said light emitting device is in the area surrounded by 5 points of (X,Y) = (0.18, 0.30), (0.22, 0.50), (0.40, 0.40), (0.45, 0.30), and (0.22, 0.20).

3. A light-emitting device as defined in claim 1 or 2, wherein said phosphor contains material belonging to the III - V group of the periodic table.

4. A light emitting device comprising the first luminescent material, and the second luminescent material absorbing light from said first luminescent material and emitting light, wherein said second luminescent material contains material belonging to the III - V group of the periodic table as said phosphor and the chromaticity coordinate of the luminescent color of the light emitted from said light-emitting device is in the area surrounded by 5 points of (X, Y) = (0. 18, 0.30), (0.22, 0.50), (0.40, 0.40), (0.45, 0.30), and (0.22, 0.20).

5. A light-emitting device as defined in any one of claims 1 to 4,wherein the number average particle diameter and the quantum yield of said phosphor are 100 nm or smaller and 40 % or higher respectively.

6. A light-emitting device as defined in any one of claims 1 to 5, wherein said phosphor contains compound having a composition ratio described in the formula (II) below.

$$[\text{Chemical Formula 1}] \quad (\text{In}_y\text{Ga}_{1-y})\, z\text{P}_{1-z} \qquad (\text{II})$$

(In the formula (II) above, $y$ and $z$ are an arbitrary real number satisfying $0<y\leq1$ and $0\leq z<1$.)

7. A light-emitting device as defined in any one of claims 1 to 6, wherein said phosphor included in said second luminescent material is obtained by processes including a heating process of microwave irradiation.

## FIG. 1

## FIG. 2

# FIG. 3

# FIG. 4

# FIG. 5

# FIG. 6

FIG. 7

## INTERNATIONAL SEARCH REPORT

| International application No. |
| --- |
| PCT/JP2005/021725 |

A.  CLASSIFICATION OF SUBJECT MATTER
*H01L33/00*(2006.01), *H01S5/028*(2006.01)

According to International Patent Classification (IPC) or to both national classification and IPC

B.  FIELDS SEARCHED

Minimum documentation searched (classification system followed by classification symbols)
*H01L33/00*(2006.01), *H01S5/028*(2006.01)

Documentation searched other than minimum documentation to the extent that such documents are included in the fields searched
Jitsuyo Shinan Koho        1922-1996   Jitsuyo Shinan Toroku Koho   1996-2005
Kokai Jitsuyo Shinan Koho   1971-2005   Toroku Jitsuyo Shinan Koho   1994-2005

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2004-263020 A  (Sumitomo Chemical Co., Ltd.),<br>24 September, 2004 (24.09.04),<br>Par. Nos. [0002], [0017]; Fig. 1<br>(Family: none) | 1,2<br>3-7 |
| X<br>Y | JP 2001-214162 A  (Japan Science and Technology Corp.),<br>07 August, 2001 (07.08.01),<br>Par. Nos. [0006], [0007], [0039], [0048];<br>Figs. 1, 2<br>(Family: none) | 1,2<br>3-7 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>08 December, 2005 (08.12.05) | Date of mailing of the international search report<br>20 December, 2005 (20.12.05) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
|---|
| PCT/JP2005/021725 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | JP 2003-034791 A  (LumiLeds Lighting U.S., LLC),<br>07 February, 2003 (07.02.03),<br>Claims; Par. Nos. [0004], [0005], [0013],<br>[0023], [0025], [0028]; Fig. 1<br>& US 6417019 B1        & EP 1248304 A2<br>& TW 536835 A | 1,2<br>3-7 |
| Y | JP 2002-525394 A  (Massachusetts Institute of<br>Technology),<br>13 August, 2002 (13.08.02),<br>Par. No. [0051]<br>& WO 2000-17655 A1      & EP 1116036 A1<br>& AU 9961485 A         & ES 2228107 T3 | 3-6 |
| Y | JP 2004-307679 A  (Fuji Photo Film Co., Ltd.),<br>04 November, 2004 (04.11.04),<br>Par. No. [0043]<br>(Family: none) | 7 |

Form PCT/ISA/210 (continuation of second sheet) (April 2005)

**INTERNATIONAL SEARCH REPORT**

| International application No. |
| --- |
| PCT/JP2005/021725 |

---

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III    Observations where unity of invention is lacking (Continuation of item 3 of first sheet)**

This International Searching Authority found multiple inventions in this international application, as follows:

```
    Since the invention of claim 1 is disclosed in JP 2004-263020 A, there
is no special technical feature between the invention of claim 1 and the
inventions of claims 2, 3, 5-7.
    There is no special technical feature between claim 1 and claim 4.
    Consequently, unity of invention is not satisfied among claims 1, 2; claim
3; claim 4; claim 5; claim 6; and claim 7.
```

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**       ☐ The additional search fees were accompanied by the applicant's protest and, where applicable,
the                                  payment of a protest fee..

                                   ☐ The additional search fees were accompanied by the applicant's protest but the applicable protest
                                   fee was not paid within the time limit specified in the invitation.

                                   ☐ No protest accompanied the payment of additional search fees.

Form PCT/ISA/210 (continuation of first sheet (2)) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004083653 A
- JP 2003318446 A
- US 6538371 B1
- JP 2004340645 A
- JP 2004340647 A
- JP 2005340387 A
- JP 2005340388 A

**Non-patent literature cited in the description**

- **TALAPIN, D.V. et al.** *J. Phys. Chem. B,* 2002, vol. 106, 12659-12663